# EUROPEAN PATENT APPLICATION

(11) **EP 2 302 674 A1**
(43) Date of publication of application: **30.03.2011**
(21) Application number: 09171570.6
(22) Date of filing: 29.09.2009
(51) Int. Cl.: H01L 23/498, H01L 25/07

(54) **Electrical terminal, electronic circuit module with an electrical terminal and corresponding method of manufacturing thereof**

(71) Applicant: ABB Research Ltd., 8050 Zürich (CH)
(72) Inventor: Schulz, Nicola, 5300 Turgi (CH); Hartmann, Samuel, 5512 Wohlenschwil (CH); Trüssel, Dominik, 5620 Bremgarten (CH)
(74) Representative: ABB Patent Attorneys

(57) **Abstract**

The invention relates to an electrical terminal (10) for an electronic circuit module, the terminal consisting of an electrical contact device (16) for externally contacting the electronic circuit module, the contact device (16) being electrically and mechanically interconnected with an integrally formed base element (14) for electrically contacting a metallised substrate (12) of the electronic circuit module when the terminal (10) is mounted on said metallised substrate (12). According to the invention the thickness of the thickness of the electrical contact device (16) is larger or at least partially larger than the thickness of the base element (14). The invention further relates to an electronic circuit module comprising at least one electrical terminal (10) and a method for manufacturing an electrical terminal (10).

## Description

### Technical Field

The invention relates to an electrical terminal for an electronic circuit module, the terminal consisting of an electrical contact device for externally contacting the electronic circuit module, the contact device being electrically and mechanically interconnected with an integrally formed base element for electrically contacting a metallised substrate of the electronic circuit module when the terminal is mounted on said metallised substrate.

### Background Art

EP 1 936 687 A1 shows an electrical terminal for a semiconductor module, the terminal comprising a first part and a second part being interconnected, wherein the first part is an integrally formed base element for electrically contacting the semiconductor module and the second part is an electrical contact device for externally contacting the electronic circuit module, the device comprising an electrical contact and a springy portion being an intermediate element located between the base element and the electrical contact.

### Summary of invention

It is an object of the invention to provide an electrical terminal for an electronic circuit module, a corresponding electronic circuit module with at least one electrical terminal and a method for assembling an electrical terminal with low electrical resistance of the terminal and stable terminal-substrate joint.

This object is achieved by an electrical terminal according to claim 1, an electronic circuit module according to claim 11 and a method for assembling an electrical terminal according to claim 13.

The electrical terminal according to the invention consists of an electrical contact device for externally contacting the electronic circuit module, the contact device being electrically and mechanically interconnected with an integrally formed base element for electrically contacting a metallised substrate of the electronic circuit module when the terminal is mounted on said metallised substrate, wherein the thickness of the electrical contact device is larger or at least partially larger than the thickness of the base element. In other words, the electrical terminal consists of two parts: the integrally formed base element and the contact device, wherein the base element and the contact device are joined together. The resulting electrical terminal is considered as a terminal which is formed by two separate parts, each part forming a functional region: the base element forming a terminal foot and the electrical contact device forming a terminal body. The terminal body may comprise more than one element. Both regions may possess different properties in order to obtain an improved functionality of the terminal "as a whole".

In general there is a plurality of possible methods to attach/mount the electrical terminal to the metallised substrate like: soldering, brazing and welding, especially ultrasonic welding, (micro) resistance welding, laser welding and other welding-methods. Preferably, the integrally formed base element and the metallised substrate are interconnected by welding in a welding region. More preferably the welding is an ultrasonic (US) welding. For ultrasonic welding, the base element (terminal foot) is chosen thinner than the contact device (terminal body). For example: the thickness of the base element is 1 mm and the thickness of the contact device is 2 mm. By means, the parameters of ultrasonic welding of the terminal to the metallised substrate can be chosen weak in such a way that neither the ceramic substrate nor the base element is damaged during the welding process. At the same time, the electrical resistance of the complete terminal can be kept low since the contact device constituting the terminal body has a higher thickness than the base element. In the case of an ultrasonic welding of the terminal to the substrate, the base element of the terminal needs to have a low thickness, preferably of 1 mm or less than 1 mm in order to obtain a stable ultrasonic welded connection without damaging the substrate, especially ceramic substrate, due to a high required ultrasonic welding energy.

Furthermore, the electrical contact device and the base element can be made of different materials, having different coatings and/or geometries, and/or can be separately optimized in further ways. This offers several advantages:

1. Simultaneously low electrical resistance of the electrical terminal and a stable terminal-substrate joint of the mounted terminal.

2. No damaging of the substrate, especially ceramic substrate, since the parameters, preferably ultrasonic welding parameters, for mounting the base element on the metallised substrate can be chosen weak.

3. Individual optimization of the base element (forming the terminal foot) and the electrical contact device (forming the terminal body) for an optimal performance of both of these terminal components.

4. Enabling of the use of low-cost materials for the two terminal components: the base element and the electrical contact device (e.g. thick die-cast aluminium for the electrical contact device).

The electrical contact device is electrically and mechanically interconnected with an integrally formed base element preferably by welding, especially ultrasonic welding, brazing, soldering, riveting, bolting and/or pinning.

The electronic circuit module preferably is a circuit module in which at least one functional device, preferably a transistor or diode, and at least one terminal are mounted, the module further comprises the substrate and a wiring layer provided by the metallization on the substrate, which wiring layer is electrically connecting the functional device with the terminal.

According to a first embodiment of the present invention, the electrical contact device consists of a single contact element or comprises at least one contact element and at least one intermediate element, the intermediate element being located between the base element and the contact element.

According to a preferred embodiment of the present invention, the thickness of the contact element and/or the thickness of the intermediate element are on average larger than the thickness of the base element. Preferably the thickness of the contact element and/or the thickness of the intermediate element are/is 1.33-times or more than 1.33-times larger than the thickness of the base element, more preferably the thickness of the contact element and/or the thickness of the intermediate element are two times larger or more than two times larger than the thickness of the base element. Especially the contact device consists of a compact contact element having a thickness of more than 5 mm.

According to another preferred embodiment of the invention, the base element is a base element of a material selected from the following materials: Cu, Ag, Al or alloys comprising Cu, Ag and/or Al. These materials are preferred materials for ultrasonic welding the base element and the metallisation (metallisation film) of the metallised substrate. The metallisation preferably is a cupper (Cu) or aluminium (Al) metallization.

According to yet another preferred embodiment of the invention, the contact element and/or the intermediate element is a contact element and/or intermediate element of a material selected from the following materials: Cu, Al or alloys comprising Cu and/or Al. Preferably the base element and the contact device of the terminal consist of the same material, preferably Cu or Al, but possessing a different treatment like for example the base element consisting of soft-annealed Cu and the contact device consisting of cold-drawn Cu.

According to a preferred embodiment of the invention, the base element and/or the contact device comprises (a) coating(s). Especially the base element and the contact device comprise the same (or different) material(s) and possess coating(s). The base element consists of Cu or Al coated with Ni, Ag or Au. The contact device (the single contact element or the contact element and/or the intermediate element) comprising a core made of Cu or Al coated with a Ni-, Ag- or Au-coating.

The base element may also consist of a composite material (e.g. CuMo or CuW) in order to obtain a better matching of the coefficients of thermal expansion of the base element and the metallised substrate.

In the case of ultrasonic (US) welding of the terminal to the substrate, the base element of the terminal preferably has a low thickness, is made of soft-annealed copper or another soft metal such as aluminium and possess no coating with a harder metal (like e.g. Ni) in their contacting region in order to obtain a stable US welded connection without damaging the substrate due to a high required ultrasonic welding energy.

According to a preferred embodiment of the present invention, the contact element comprises a junction fastener, especially a junction lug.

According to yet another preferred embodiment of the present invention, a part of the base element engages a recess of the electrical contact device or a part of the electrical contact device engages a recess of the base element, especially for interconnecting the base element and the contact device.

According to another preferred embodiment of the present invention, the base element is an "L"-shaped base element of the terminal, the "L"-shaped base element comprising a first arm for mounting the terminal to the metallised substrate and a second arm being interconnected with the electrical contact device. An "L"-shaped base element can be produced easily by bending a (metal) plate.

According to yet another preferred embodiment of the present invention, the electrical contact device of the mounted electrical terminal is located with a distance to the metallised substrate.

The invention further relates to an electronic circuit module comprising at least one aforementioned electrical terminal and a metalized substrate.

According to a preferred embodiment of the present invention, the base element and the metallisation of the metallised substrate are formed in one piece. The base element of this preferred embodiment is "an integrated part" of the metallised substrate. The base element especially is a part of the metallisation film being bended up.

The invention further relates to a method for assembling an electrical terminal of an electronic circuit module, the terminal consisting of an electrical contact device for externally contacting the electronic circuit module and an integrally formed base element for electrically contacting a metallised substrate of the electronic circuit module when the electrical terminal is mounted. According to the invention the method comprises the steps of (a) providing an assembly of a preassembled base element mounted on the metallised substrate and subsequently (b) connecting the base element with the electrical contact device, wherein the thickness of the electrical contact device is larger or at least partially larger than the thickness of the base element.

According to a preferred embodiment of the present invention, the base element and the metallisation of the metallised substrate are formed in one piece. The base element of this preferred embodiment is "an integrated part" of the metallised substrate. The base element especially is a part of the metallisation film being bended up.

Preferably, the electrical contact device of the mounted electrical terminal is located with a distance to the metallised substrate.

### Brief description of drawings

Additional details, features, characteristics and advantages of the object of the invention are disclosed in the subclaims, the figures and the following description of the respective figure and examples, which - in an exemplary fashion - show one embodiment and example of an electrical terminal according to the invention.

In the drawings:

Fig. 1 is a cross-sectional view of an electrical terminal according to a first embodiment of the invention, wherein the terminal is mounted on a metallised substrate;

Fig. 2 is a cross-sectional view of an electrical terminal according to a second embodiment of the invention;

Fig. 3 is a cross-sectional view of an electrical terminal according to a third embodiment of the invention;

Fig. 4 is a cross-sectional view of an electrical terminal according to a fourth embodiment of the invention;

Fig. 5 shows two steps of a method for assembling and mounting an electrical terminal;

Fig. 6 shows two steps of a method for assembling an electrical terminal according to the invention; and

Fig. 7 shows two steps of the method for assembling another electrical terminal according to the invention.

### Description of embodiments

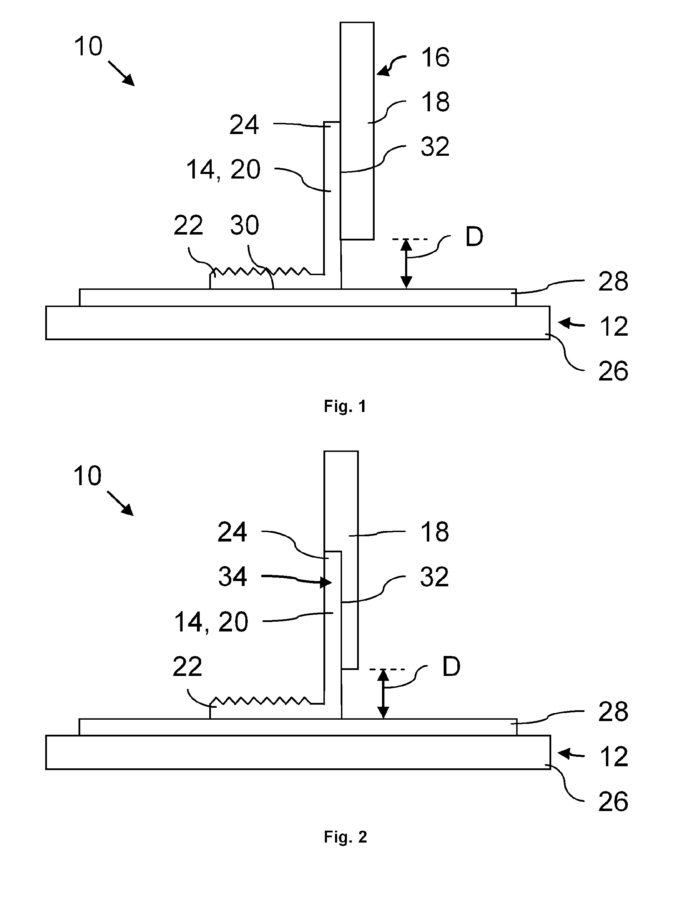

Fig. 1 shows an electrical terminal 10 mounted on a metallised substrate 12 of an electronic circuit module (not shown in further detail). The electrical terminal 10 comprises an integrally formed base element 14 for electrically contacting a metalized substrate 12 and an electrical contact device 16 for externally contacting a contact of a functional device (e. g. a power transistor - not shown) of the electronic circuit module via the terminal 10 and the metallised substrate 12. The electrical contact device 16 shown in Fig. 1 is a single contact element 18 and the base element 14 is formed as an "L"-shaped base element 20 of the terminal 10. The "L"-shaped base element 20 comprises a first arm 22 for mounting the electrical terminal 10 on the metallised substrate 12 and a second arm 24 being interconnected with the electrical contact device 16.

The metallised substrate 12 comprises a metallisation (or metallisation film) 28 and a board 26, especially a ceramic board. In this special case the metallised substrate 12 is a metallised ceramic substrate. The base element 14 is mounted on the metallisation 28 of the metallised substrate 12 by a welding process connecting the base element 14 and the metallised substrate in a connecting region, to be more precisely: a welding region 30. By the welding process, especially the welding process of ultrasonic welding, the base element 14 of the terminal is electrically and mechanically connected with the metallisation 28 of the metallised substrate 12. The contact device 16 is electrically and mechanically interconnected with the integrally formed base element 14 in an interconnection region 32 for electrically contacting the metallised substrate 12 of the electronic circuit module when the terminal 10 is mounted on said metallised substrate 12.

The integrally formed base element 14 is electrically and mechanically interconnected with the contact device 16 in such a manner, that the electrical contact device 16 of the mounted electrical terminal 10 is located with a distance D to the metallisation of the metallised substrate 12.

The thickness of the contact device 16 (or contact element 18 respectively) is on average two times larger than the thickness of the base element 14.

The base element 14 is a base element 14 made of a material selected from the following materials: Cu, Ag, Al or alloys comprising Cu, Ag and/or Al. The contact device 16 is a contact device 18 selected from the following materials: Cu, Al or alloys comprising Cu and/or Al. The base element 14 and/or the contact device 16 comprise coatings.

Fig. 2 shows an electrical terminal 10 which essentially is in accordance with the terminal 10 shown in Fig. 1. The contact device 16 of the electrical terminal 10 shown in Fig. 2 shows a recess 34. A part of the base element 14 engages the recess 34 of the electrical contact device 16 for interconnecting the base element 14 and the electrical contact device 16. The thickness of the contact device 16 (or contact element 18 respectively) is on average more than 1.33 times larger than the thickness of the base element 14.

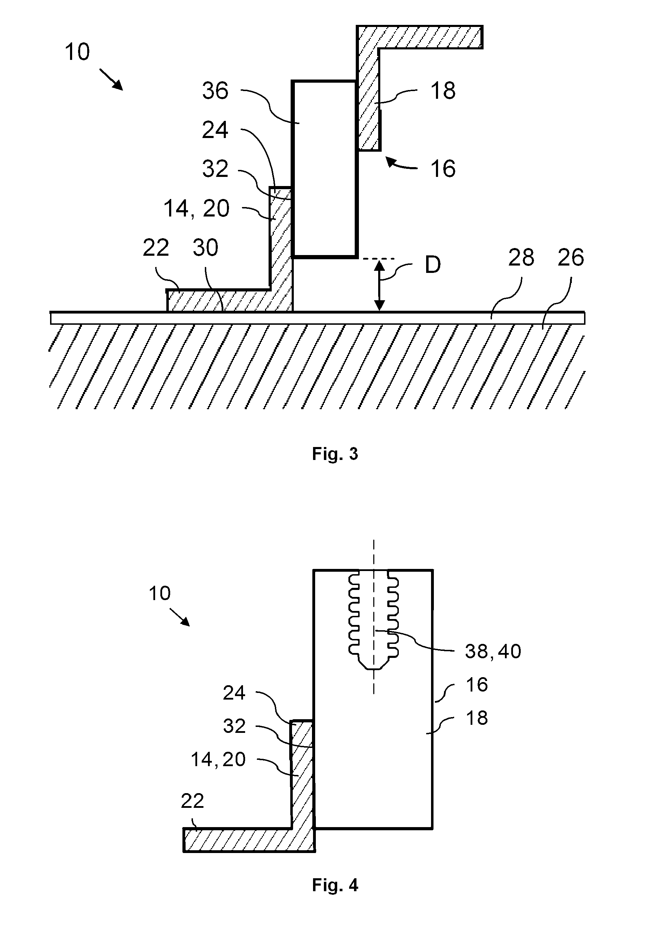

Fig. 3 shows an electrical terminal 10 which essentially is in accordance with the terminals 10 shown in Figs. 1 and 2. The electrical contact device 16 comprises an electrical contact element 18 and an intermediate element 36 located between the base element 14 and the contact element 18. The thickness of the contact device 16 is on average more than two times larger than the thickness of the base element 14.

The contact element 18 is a contact element 18 selected from the following materials: Cu, Al or alloys comprising Cu and/or Al and/or the intermediate element 36 is an intermediate element 36 selected from the following materials: Cu, Al or alloys comprising Cu and/or Al.

Fig. 4 shows a further electrical terminal 10 which essentially is in accordance with the terminals 10 shown in Figs. 1 and 2. The thickness of the contact device 16 (or contact element 18 respectively) is on average more than four times larger than the thickness of the base element 14. The contact element 18 of the terminal 10 shown in Fig. 4 comprises a junction fastener 38 being a threaded blind hole 40.

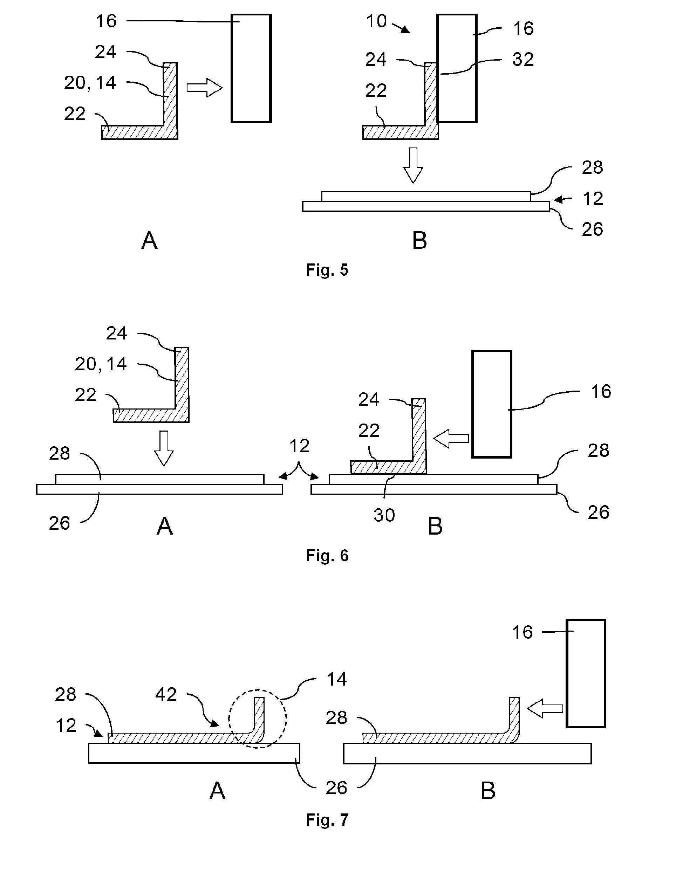

Fig. 5 depicts a first method for assembling and mounting the terminal 10 by interconnecting the base element 14 with the contact device 16 (step A) and afterwards mounting the resulting terminal 10 to the metallised substrate 12 (step B). The thickness of the electrical contact device of the terminal 10 is larger than the thickness of its base element.

Fig. 6 depicts another method for assembling the terminal 10, the method comprising the steps of:
- mounting the base element 14 on the metallised substrate 12 (step A) resulting in an assembly of a preassembled base element 14 mounted on the metallised substrate 12 and afterwards
- (inter)connecting the mounted base element 14 with the electrical contact device 16 (step B). The thickness of the electrical contact device is larger than the thickness of the base element.

Fig. 7 depicts yet another method for assembling the terminal 10, the method comprising the steps of:
- providing an assembly of a preassembled base element 14 mounted on the metallised substrate 12, wherein the base element 14 and the metallisation 28 of the metallised substrate 12 are formed in one piece 42 (step A) and afterwards
- connecting the base element 14 with the electrical contact device 16 (step B). The thickness of the electrical contact device is larger than the thickness of the base element. The base element 14 is "an integrated part" of the metallised substrate 12, namely a part of the metallisation (film) 28 being bended up. By this bending of the metallisation the second arm 24 of an "L"-shaped base element is formed.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: electrical terminal
- 12: metalized substrate
- 14: base element
- 16: contact device
- 18: contact element
- 20: "L"-shaped base element
- 22: first arm
- 24: second arm
- 26: board
- 28: metal film
- 30: welding region
- 32: interconnection region
- 34: recess
- 36: intermediate element
- 38: junction fastener
- 40: threaded blind hole
- 42: one piece

## Claims

1. Electrical terminal (10) for an electronic circuit module, the terminal consisting of an electrical contact device (16) for externally contacting the electronic circuit module, the contact device (16) being electrically and mechanically interconnected with an integrally formed base element (14) for electrically contacting a metallised substrate (12) of the electronic circuit module when the terminal (10) is mounted on said metallised substrate (12), **characterized in that** the thickness of the electrical contact device (16) is larger or at least partially larger than the thickness of the base element (14).

2. Electrical terminal according to claim 1, wherein the electrical contact device (16) consists of a single electrical contact element (18) or comprises at least one electrical contact element (18) and at least one intermediate element (36) located between the base element (14) and the contact element (18).

3. Electrical terminal according to claim 2, wherein the thickness of the contact element (18) and/or the thickness of the intermediate element (36) is on average larger than the thickness of the base element (14), preferably 33% or more than 33% larger than the thickness of the base element (14), more preferably 100% larger or more than 100% larger than the thickness of the base element (14).

4. Electrical terminal according to one of claims 1 or 3, wherein the base element (14) is a base element (14) made of a material selected from the following materials: Cu, Ag, Al or alloys comprising Cu, Ag and/or Al.

5. Electrical terminal according to one of claims 2 to 4, wherein the contact element (18) and/or the intermediate element (36) is a contact element (18) and/or intermediate element (36) selected from the following materials: Cu, Al or alloys comprising Cu and/or Al.

6. Electrical terminal according to one of claims 1 to 5, wherein the base element (14) and/or the contact device (16) comprise coatings.

7. Electrical terminal according to one of claims 2 to 6, wherein the contact element (18) comprises a junction fastener (38).

8. Electrical terminal according to one of claims 1 to 7, wherein a part of the base element (14) engages a recess (34) of the electrical contact device (16) or a part of the electrical contact device (16) engages a recess of the base element (14).

9. Electrical terminal according to one of claims 1 to 8, wherein the base element (14) is an "L"-shaped base element (20), the "L"-shaped base element (20) comprising a first arm (22) for mounting the terminal on the metalized substrate (12), wherein a second arm (24) is interconnected with the electrical contact device (16).

10. Electrical terminal according to one of claims 1 to 9, wherein electrical contact device (16) of the mounted electrical terminal (10) is located with a distance (D) to the metallised substrate (12).

11. Electronic circuit module comprising at least one electrical terminal (10) according to one of claims 1 to 10 and a metallised substrate (12).

12. Electronic circuit module according to claim 11, wherein the base element (14) of the electrical terminal (10) and the metallisation (28) of the metalized substrate (12) are formed in one piece (42).

13. Method for assembling an electrical terminal of an electronic circuit module, the terminal consisting of an electrical contact device for externally contacting the electronic circuit module and an integrally formed base element for electrically contacting a metallised substrate of the electronic circuit module when the electrical terminal is mounted, **characterized by** the steps:
- providing an assembly of a preassembled base element mounted on the metallised substrate; and subsequently
- connecting the base element with the electrical contact device, wherein the thickness of the electrical contact device is larger or at least partially larger than the thickness of the base element.

14. Method according to claim 13, wherein the base element and the metallisation of the metallised substrate are formed in one piece.
